# EUROPÄISCHE PATENTSCHRIFT

(11) **EP 0 593 924 B1**
(45) Veröffentlichungstag und Bekanntmachung des Hinweises auf die Patenterteilung: **28.02.1996**
(21) Anmeldenummer: 93115314.2
(22) Anmeldetag: 23.09.1993
(51) Int. Cl.: H01J 37/32, H01J 37/34, H05H 1/46

(54) **Vorrichtung zum Erzeugen eines Plasmas mittels Kathodenzerstäubung**
Device for producing plasma using cathodic sputtering
Dispositif pour la production d'un plasma au moyen d'une pulvérisation cathodique

(30) Priorität: 17.10.1992 DE 4235064
(43) Veröffentlichungstag der Anmeldung: 27.04.1994
(73) Patentinhaber: LEYBOLD AKTIENGESELLSCHAFT, D-63450 Hanau (DE)
(72) Erfinder: Latz, Rudolf, Dr., D-63110 Rodgau-Dudenhofen (DE)
(74) Vertreter: Schickedanz, Willi, Dipl.-Ing.

(56) Entgegenhaltungen:
- EP-A- 0 271 341
- EP-A- 0 403 418
- WO-A-86/06923
- WO-A-92/07969
- DE-A- 4 042 289

## Beschreibung

Die Erfindung betrifft eine Vorrichtung zum Erzeugen eines Plasmas mittels Kathodenzerstäubung nach dem Oberbegriff des Patentanspruchs 1.

Auf zahlreichen Gebieten der Technik ist es erforderlich, dünne Schichten auf Substrate aufzubringen. Beispielsweise werden Glasscheiben beschichtet, um ihnen zu besonderen Eigenschaften zu verhelfen, oder es werden Uhrengehäuse aus einem weniger edlen Material mit einer aus edlem Material bestehenden Schicht überzogen.

Für das Aufbringen dünner Schichten auf Substrate sind bereits zahlreiche Verfahren vorgeschlagen worden, von denen lediglich die Galvanotechnik und das Beschichten aus einem Plasma heraus erwähnt seien. Das Beschichten aus dem Plasma hat in den letzten Jahren immer mehr an Bedeutung gewonnen, weil es eine Vielzahl von Materialien als Beschichtungsmaterial zuläßt.

Um ein für die Beschichtung geeignetes Plasma herzustellen, sind ebenfalls verschiedene Verfahren vorgeschlagen worden. Von diesen Verfahren ist das Kathodenzerstäubungsverfahren, das auch Sputtern genannt wird, wegen seiner hohen Beschichtungsraten von großem Interesse.

Bei einer bekannten Vorrichtung für die Erzeugung eines Plasmas hoher Dichte kommt ein Hochfrequenz-Generator zum Einsatz, der 13,56 MHz-Wellen entlang eines Magnetfelds sendet, welches durch einen externen Magnetfeldgenerator in den Entladungsraum gelangt (US-PS 4 990 229). Mit Hilfe dieser Vorrichtung werden Helicon-Whistler-Wellen in einem Plasmaraum angeregt, die zu einer besonders hohen Plasmaaktivierung führen. Um bestimmte Wellenmoden für Whistler-Wellen anzuregen, sind besondere Antennenstrukturen vorgesehen. Eine Antenne für die Anregung von Whistler-Wellen ist bei einer Anregungsfrequenz von 13,56 MHz derart ausgelegt, daß sie die m = 0 und m = 1 Moden anregt.

Der Nachteil der bekannten Vorrichtung besteht darin, daß mit ihr zwar ein hochaktiviertes und hochionisiertes Plasma erzeugt werden kann, daß es jedoch nicht möglich ist, eine Sputterbeschichtung durchzuführen.

Es ist weiterhin eine Sputteranlage bekannt, die eine Hochfrequenz-Anregungsspule mit vier Windungen aufweist, welche zwischen einem scheibenförmigen Target und einem Substrathalter in einer herkömmlichen DC-Dioden-Anlage angeordnet ist (Matsuo Yamashita: "Effect of magnetic field on plasma characteristics of built-in high-frequency coil type sputtering apparatus", J. Vac. Sci. Technol. A 7 (4), Jul/Aug 1989, S. 2752 - 2757). Senkrecht zur Achse der Hochfrequenz-Anregungsspule verläuft außerdem ein statisches Magnetfeld, das in den Plasmabereich eindringt. Mit dieser Sputteranlage ist es indessen nicht möglich, Whistler-Wellen zu erzeugen.

Der Erfindung liegt die Aufgabe zugrunde, den Plasmaraum einer Magnetron-Kathode derart mit einer HF-Welle zu beaufschlagen, daß sich Whistler-Wellen ausbilden können.

Diese Aufgabe wird gemäß den Merkmalen des Patentanspruchs 1 gelöst.

Der mit der Erfindung erzielte Vorteil besteht insbesondere darin, daß aufgrund einer höheren Volumenwirksamkeit ein wesentlich höherer Ionisationsgrad als bei herkömmlichen Vorrichtungen erzielt werden kann. Durch die Anregung von Whistler-Wellen im Plasma wird das Plasma besonders effektiv ionisiert. Aber auch ohne Anregung von "Whistler-Wellen", d. h. bei normaler Anregung, wird ein höherer Plasmaionisationsgrad erzeugt als bei Anlagen, in denen keine Welleneinkopplung erfolgt. Durch die Erfindung werden die hohe Plasmadichte und die Sputterbeschichtung miteinander kombiniert.

Ein Ausführungsbeispiel der Erfindung ist in der Zeichnung dargestellt und wird im folgenden näher beschrieben. Es zeigen:
- Fig. 1: eine Plasmakammer mit einer Magnetronkathode und einer Spulenantenne;
- Fig. 2: eine perspektivische Ansicht der Magnetronkathode und der Spulenantenne gemäß Fig. 1;
- Fig. 3: eine erste Hochfrequenzspulenvorrichtung;
- Fig. 4: eine zweite Hochfrequenzspulenvorrichtung;
- Fig. 5: eine dritte Hochfrequenzspulenvorrichtung.

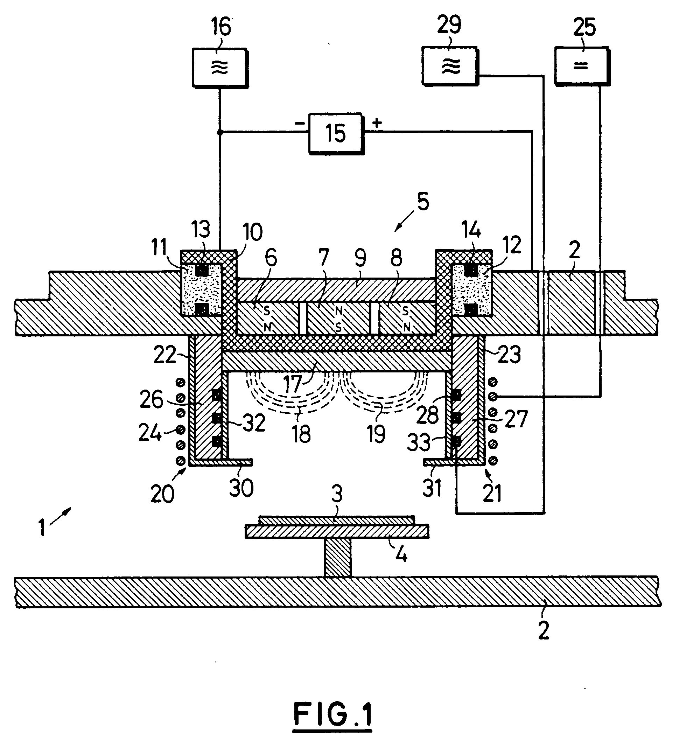

In der Fig. 1 ist ein Ausschnitt aus einer Plasmakammer 1 gezeigt, die von einem Gehäuse 2 umgeben ist. Im unteren Bereich des Gehäuses 2 befindet sich ein Substrat 3 auf einem Drehteller 4. Oberhalb des Substrats 3, das geätzt oder beschichtet werden soll, ist eine Magnetronkathode 5 vorgesehen, die ihrerseits drei Dauermagnete 6, 7, 8, ein Joch 9 sowie eine Kathodenwanne 10 aufweist. Die Kathodenwanne 10 ruht auf Isolatoren 11, 12, die mit Dichtungen 13, 14 versehen sind. Diese Isolatoren 11, 12 sind in die Oberseite des Gehäuses 2 eingebettet. An der Elektrodenwanne 10 liegt der Minuspol einer Gleichstromversorgung 15, deren Pluspol mit der Gehäusemasse des Rezipienten 2 verbunden ist. Altemativ zur Gleichstromversorgung 15 kann auch noch eine Hochfrequenzversorgung 16 vorgesehen sein. Unterhalb der Kathodenwanne 10 befindet sich ein Target 17, durch das die Magnetfeldlinien 18, 19 der Dauermagnete 6 bis 8 stoßen. Zu beiden Seiten des Targets 17 ist eine L-förmige Abschirmung 20, 21 angeordnet.

Um den vertikalen Teil 22, 23 der Abschirmung 20, 21 ist eine Spule 24 gewickelt, die an einer Gleichspannungsquelle 25 liegt. Die Spule 24 ist eine Spule für die Erzeugung eines zusätzlichen Magnetfelds im Plasmaraum. Sie wird bevorzugt mit Gleichstrom betrieben. Vor dem vertikalen Teil 22, 23 ist ein Isolator 26, 27 vorgesehen, der Nuten aufweist, in denen sich eine weitere Spule 28 befindet, die an eine Hochfrequenzquelle 29 angeschlossen ist. Der Isolator 26, 27 wird auf seiner Unterseite durch einen horizontalen Teil 30, 31 hinter der Abschirmung 20, 21 abgeschlossen. Dieser Teil der Abschirmung 20, 21 ist elektrisch isoliert und kann entweder geerdet oder auf ein beliebiges elektrisches Potential gelegt werden. Er stellt die effektive Anode der Vorrichtung dar und kann gleichzeitig als Verteilungsblende genutzt werden. Vor der als Antenne wirkenden Spule 28 ist eine Abdeckplatte 32, 33 aus einem isolierenden Material, z. B. aus Glas oder aus Metall, angeordnet. Im Falle einer metallenen Abdeckplatte ist diese isoliert angebracht und kann entweder elektrisch floatend sein oder von außen mit einer beliebigen Spannung beaufschlagt werden. Die Hochfrequenzquelle 29 erzeugt mittels der Antennenspule 28 im Plasmaraum elektromagnetische Wellen, die sich zu Whistler-Wellen ausbilden können. Durch das Zusammenspiel der elektromagnetischen Wellen der Spule 28 mit dem Feld der Spule 24 kommt es zur Anregung von Helicon-Moden im Plasma.

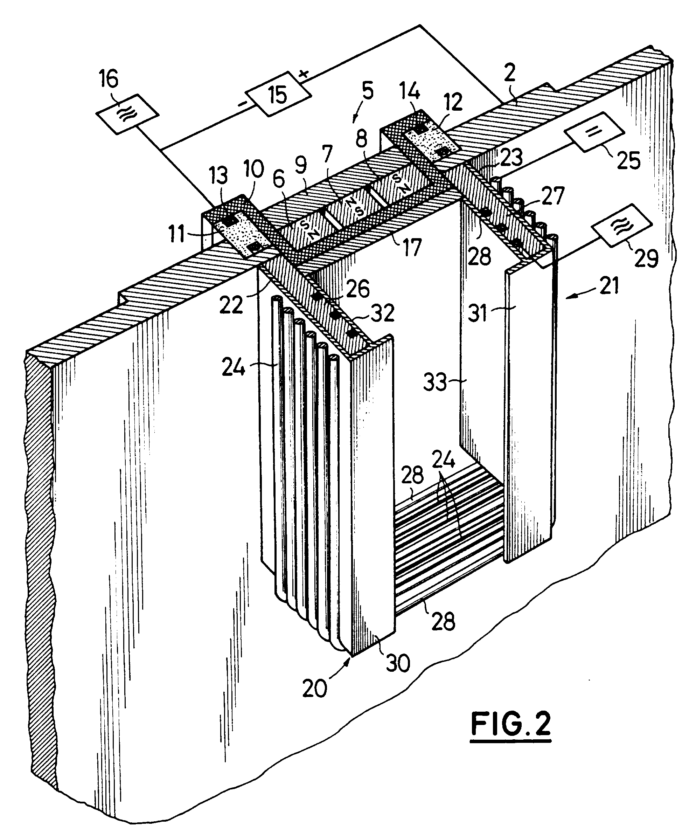

Die Fig. 2 zeigt die Magnetronkathode 5 mit der Abschirmung 20, 21 und den beiden Spulen 24 und 28. Man erkennt hierbei deutlich, daß die Spulen 24, 28 derart in die Abschirmung 20, 21 eingebettet sind bzw. diese derart umschlingen, daß die bei Stromdurchfluß entstehenden Magnetfelder senkrecht auf dem Target 17 stehen. Das Substrat 3 und der Drehteller 4 sind in der Fig. 2 weggelassen. Die Versorgungsquellen 25 und 29 sind innerhalb des Gehäuses 2 dargestellt, obwohl sie sich in Wirklichkeit außerhalb dieses Gehäuses 2 befinden, wie es die Fig. 1 zeigt.

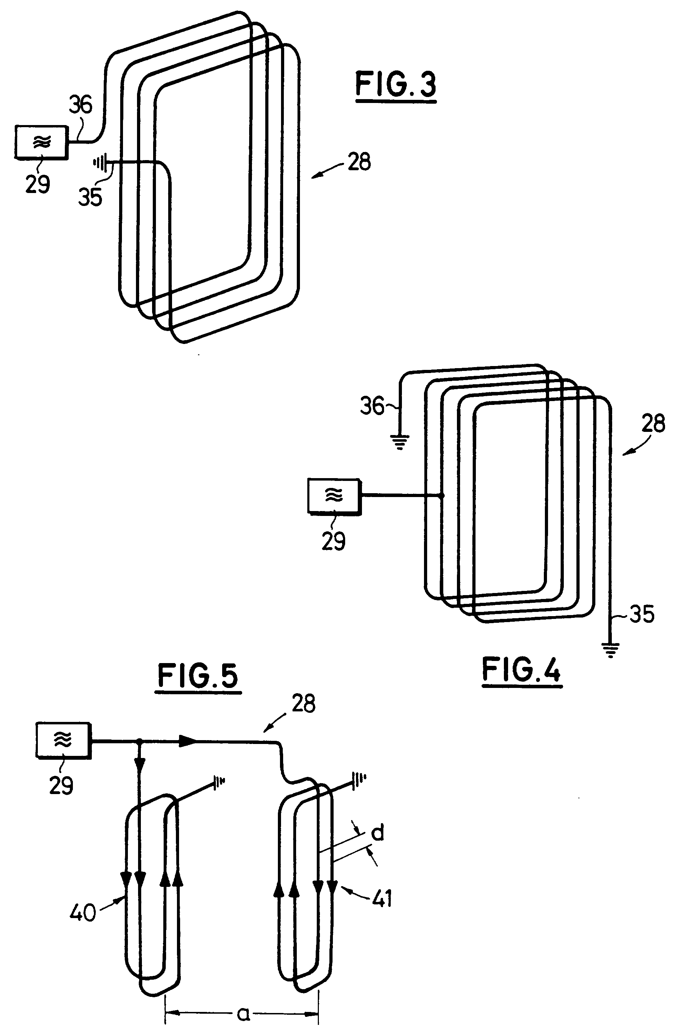

Eine genauere Darstellung der Hochfrequenzspule 28 zeigen die Fig. 3 bis 5. In der Fig. 3 ist die Spule 28 im Uhrzeigersinn gewickelt und mit ihrem einen Ende an Masse oder Erde gelegt, während ihr anderes Ende 36 mit der Hochfrequenzquelle 29 verbunden ist.

Bei der Spulenanordnung gemäß Fig. 4 sind beide Enden 35, 36 der Spule 28 an Erde oder Masse gelegt, während die Hochfrequenzquelle 29 an die Mitte der Spule 28 angeschlossen ist.

In der Fig. 5 ist die Spule 28 in zwei Hälften 40, 41 unterteilt, wobei der Wickelsinn dieser beiden Hälften 40, 41 entgegengesetzt ist. Beide Hälften sind in einem bestimmten Abstand voneinander in die Nuten eines Isolators eingebettet. Die eine dieser Hälften 40 liegt in dem Isolatorteil 26 eingebettet, während die andere Hälfte 41 in den Nuten des Isolatorteils 27 liegt. Der Wickelsinn der Spulenhälften 40, 41 ist dabei derart, daß ihre Magnetfelder parallel zur Oberfläche des Targets 17 verlaufen. Mit d ist die Nutbreite bezeichnet, während mit a der Abstand zwischen den Spulenteilstücken 40, 41 bezeichnet ist.

## Patentansprüche

1. Vorrichtung zum Erzeugen eines Plasmas mittels Kathodenzerstäubung, mit
a) einer Plasmakammer (1),
b) einem Target (17) in dieser Plasmakammer (1), das mit einer Elektrode (10) verbunden ist, die an einer Stromversorgung (15, 16) liegt,
c) einem Magnetron (5), dessen Magnetfeld (18, 19) aus dem Target (17) austritt und in dieses wieder eintritt,
d) Abschirmblechen (22, 23), die senkrecht zur Oberfläche des Targets (17) verlaufen und an wenigstens zwei Seiten des Targets (17) vorgesehen sind,
**gekennzeichnet durch,**
e) eine erste Spule (24), die um die Abschirmbleche (22, 23) gewickelt ist und an einer Gleichspannungsquelle (25) liegt, und
f) eine zweite Spule (28), die in einem Abstand von der ersten Spule (24) angeordnet ist und an einer Hochfrequenzquelle (29) liegt, die vorzugsweise im MHz-Bereich betrieben wird.

2. Vorrichtung nach Anspruch 1, **dadurch gekennzeichnet,** daß der Abstand zwischen der ersten und der zweiten Spule (24, 28) durch ein Abschirmblech (22, 23) und einen Isolator (26, 27) gebildet ist.

3. Vorrichtung nach Anspruch 1, **dadurch gekennzeichnet,** daß die Abschirmbleche (22, 23) die Form eines L besitzen, wobei der untere Schenkel des L nach innen in den Plasmaraum (1) ragt und von den übrigen Abschirmblechen elektrisch isoliert ist und an beliebigem elektrischen Potential liegt.

4. Vorrichtung nach Anspruch 1, **dadurch gekennzeichnet,** daß die zweite Spule (24) als Hohlröhre ausgebildet ist und von einem Kühlmittel durchströmt wird.

5. Vorrichtung nach Anspruch 2, **dadurch gekennzeichnet,** daß die Isolatoren (26, 27) auf ihren nach innen gerichteten Seiten Nuten besitzen, in welche die Wicklungen der zweiten Spule (28) eingebettet sind.

6. Vorrichtung nach Anspruch 1, **dadurch gekennzeichnet,** daß die zweite Spule (28) zum Raum zwischen Target (17) und Substrat (3) hin durch einen elektrischen Isolator (32, 33) abgeschirmt ist.

7. Vorrichtung nach Anspruch 1, **dadurch gekennzeichnet,** daß die zweite Spule (28) zum Raum zwischen Target (17) und Substrat (3) hin durch eine nichtmagnetische Metallplatte abgeschirmt ist, die isoliert aufgehängt ist und an einem beliebigen elektrischen Potential liegt.

8. Vorrichtung nach Anspruch 1, **dadurch gekennzeichnet,** daß die zweite Spule (28) mit ihrem einen Ende (36) an der Hochfrequenzquelle (29) und mit ihrem anderen Ende (35) an Masse oder Erde angeschlossen ist.

9. Vorrichtung nach Anspruch 1, **dadurch gekennzeichnet,** daß die zweite Spule (28) mit ihren beiden Enden (36, 35) an Masse oder Erde angeschlossen ist, während ein mittlerer Bereich dieser Spule (28) an einem Hochfrequenzgenerator (29) liegt.

10. Vorrichtung nach Anspruch 1, **dadurch gekennzeichnet,** daß die zweite Spule (28) in zwei Hälften unterteilt ist, von denen die eine Hälfte (40) eine Wickelrichtung im Uhrzeigersinn und die andere Hälfte (41) eine Wickelrichtung im Gegenuhrzeigersinn hat.

11. Vorrichtung nach Anspruch 1, **dadurch gekennzeichnet,** daß das von der ersten Spule erzeugte Gleichfeld eine Stärke von ca 500x10⁻⁴ T (500 Gauss) aufweist.

12. Vorrichtung nach Anspruch 1, **dadurch gekennzeichnet,** daß die Hochfrequenzquelle (29) bei einer Frequenz von 13,56 MHz betrieben wird.

## Claims

1. A device for producing a plasma by means of cathodic sputtering, having
a) a plasma chamber (1),
b) in this plasma chamber (1) a target (17) which is connected to an electrode (10) to which a power supply (15, 16) is supplied,
c) a magnetron (5) whereof the magnetic field (18, 19) emerges from the target (17) and re-enters the latter,
d) screening plates (22, 23) which run perpendicular to the surface of the target (17) and are provided on at least two sides of the target (17),
characterized by
e) a first coil (24) which is wound around the screening plates (22, 23) and to which a d.c. voltage source (25) is applied, and
f) a second coil (28) which is arranged at a spacing from the first coil (24) and to which a high-frequency source (29), preferably operated in the MHz range, is applied.

2. A device according to Claim 1, characterized in that the spacing between the first and the second coil (24, 28) is formed by a screening plate (22, 23) and an insulator (26, 27).

3. A device according to Claim 1, characterized in that the screening plates (22, 23) have the shape of an L, the lower limb of the L projecting inwards into the plasma chamber (1) and being electrically insulated by the rest of the screening plates, and having applied to it any electrical potential.

4. A device according to Claim 1, characterized in that the second coil (24) is constructed as a hollow tube and coolant flows through it.

5. A device according to Claim 2, characterized in that the insulators (26, 27) have, on their inwardly directed sides, grooves in which the windings of the second coil (28) are embedded.

6. A device according to Claim 1, characterized in that the second coil (28) is screened towards the space between the target (17) and the substrate (3) by an electrical insulator (32, 33).

7. A device according to Claim 1, characterized in that the second coil (28) is screened towards the space between the target (17) and the substrate (3) by a non-magnetic metal plate which is suspended in insulated manner and to which any electrical potential is applied.

8. A device according to Claim 1, characterized in that the second coil (28) is connected by means of its one end (36) to the high-frequency source (29) and by means of its other end (35) to ground or earth.

9. A device according to Claim 1, charactetized in that the second coil (28) is connected by means of both its ends (36, 35) to ground or earth, while a central region of this coil (28) has a high-frequency generator (29) applied to it.

10. A device according to Claim 1, characterized in that the second coil (28) is divided into two halves, of which the one half (40) has its windings directed clockwise and the other half (41) has its windings directed anti-clockwise.

11. A device according to Claim 1, characterized in that the d.c. field produced by the first coil has a strength of approximately 500 x 10⁻⁴ T (500 gauss).

12. A device according to Claim 1, characterized in that the high-frequency source (29) is operated at a frequency of 13.56 MHz.

## Revendications

1. Dispositif de production d'un plasma au moyen d'une pulvérisation cathodique comportant
a) une chambre de plasma (1),
b) une cible (17) dans cette chambre de plasma (1), qui est reliée à une électrode (10), laquelle est connectée à une alimentation électrique (15, 16),
c) un magnétron (5) dont le champ magnétique (18, 19) sort de la cible (17) et entre à nouveau dans celle-ci,
d) des tôles de blindage (22, 23) qui sont perpendiculaires à la surface de la cible (17) et qui sont prévues sur au moins deux côtés de la cible (17),
caractérisé par
e) une première bobine (24) qui est enroulée autour des tôles de blindage (22, 23) et qui est connectée à une source de tension continue (25) et
f) une seconde bobine (28) qui est placée à distance de la première bobine (24) et qui est reliée à une source de haute fréquence (29), qui fonctionne de préférence dans la gamme des MHz.

2. Dispositif selon la revendication 1, caractérisé en ce que la distance entre la première et la deuxième bobine (24, 28) est formée par une tôle de blindage (22, 23) et un isolateur (26, 27).

3. Dispositif selon la revendication 1, caractérisé en ce que les tôles de blindage (22, 23) ont la forme d'un L, la branche inférieure du L pénétrant vers l'intérieur dans la chambre de plasma (1) et étant isolée électriquement des autres tôles de blindage et étant reliée à un potentiel électrique quelconque.

4. Dispositif selon la revendication 1, caractérisé en ce que la seconde bobine (24) est un tube creux et est traversée par un réfrigérant.

5. Dispositif selon la revendication 2, caractérisé en ce que les isolateurs (26, 27) possèdent, sur leur côté dirigé vers l'intérieur, des rainures dans lesquelles sont noyées les enroulements de la seconde bobine (28).

6. Dispositif selon la revendication 1, caractérisé en ce que la seconde bobine (28) est protégée vers l'espace entre la cible (17) et le substrat (3), par un isolateur électrique (32, 33).

7. Dispositif selon la revendication 1, caractérisé en ce que la seconde bobine (28) est protégée vers l'espace entre la cible (17) et le substrat (3), par une plaque métallique non magnétique, qui est suspendue de manière isolée et qui est reliée à un potentiel électrique quelconque.

8. Dispositif selon la revendication 1, caractérisé en ce que la seconde bobine (28) est raccordée par l'une de ses extrémités (36) à la source de haute fréquence (29) et par son autre extrémité (35), à la masse ou à la terre.

9. Dispositif selon la revendication 1, caractérisé en ce que la seconde bobine (28) est raccordée par ses deux extrémités (36, 35) à la masse ou à la terre, tandis qu'une zone centrale de cette bobine (28) est reliée à un générateur à haute fréquence (29).

10. Dispositif selon la revendication 1, caractérisé en ce que la seconde bobine (28) est partagée en deux moitiés dont une moitié (40) possède un sens d'enroulement dans le sens des aiguilles d'une montre et l'autre moitié (41) un sens d'enroulement dans le sens contraire aux aiguilles d'une montre.

11. Dispositif selon la revendication 1, caractérisé en ce que le champ continu produit par la première bobine présente une intensité d'environ 500 x 10⁻⁴T (500 Gauss).

12. Dispositif selon la revendication 1, caractérisé en ce que la source de haute fréquence (29) fonctionne à une fréquence de 13,56 MHz.
